# FASCICULE DE BREVET EUROPEEN

(11) **EP 1 300 378 B1**
(45) Date de publication et mention de la délivrance du brevet: **10.10.2007**
(21) Numéro de dépôt: 02292108.4
(22) Date de dépôt: 28.08.2002
(51) Int. Cl.: C04B 37/00, C04B 41/00, C09J 5/02

(54) **Procédé pour améliorer les propriétés d'adhésion d'un substrat céramique**
Verfahren zur Verbesserung der Hafteigenschaften eines Keramiksubstrats
Process for improving the adhesive properties of a ceramic substrate

(30) Priorité: 21.09.2001 FR 0112185
(43) Date de publication de la demande: 09.04.2003
(73) Titulaire: Alstom, 92300 Levallois-Perret (FR)
(72) Inventeur: Petitbon, Alain, 64000 Pau (FR); Evieux, Jérôme, 65000 Tarbes (FR); Baziard, Yves, 65000 Tarbes (FR)
(74) Mandataire: Habasque, Etienne J. Jean-François

(56) Documents cités:
- WO-A-98/03600
- DE-A- 19 860 135
- US-A- 5 473 137

## Description

L'invention se rapporte à un procédé pour améliorer les propriétés d'adhésion d'un substrat céramique de la famille des non-oxydes en vue de son collage. Le procédé selon l'invention s'applique en particulier à la préparation des substrats en céramique supportant des composants semi-conducteurs de puissance et destinés à être collés sur un collecteur de refroidissement pour être utilisés dans les onduleurs du domaine ferroviaire.

Il est connu, dans le domaine des onduleurs, d'assembler par collage un substrat en nitrure d'aluminium AlN, supportant des composants de puissance, sur un collecteur de refroidissement. Ces assemblages par collage comportent habituellement une étape de préparation des surfaces à encoller consistant à nettoyer les surfaces par procédés chimiques, mécaniques ou thermiques. Pour les assemblages les plus récents, le nettoyage des surfaces est réalisé par un procédé de nettoyage par plasma froid constitué d'un mélange d'argon et d'oxygène. Ce procédé qui est utilisable en salle blanche présente toutefois l'inconvénient de nécessiter une enceinte sous vide, ce qui le rend long et compliqué.

Par ailleurs, les procédés de nettoyage utilisés jusqu'à présent polluent généralement les composants de puissance qui sont placés sur le substrat céramique et les liaisons céramiques/polymères obtenues par ces collages sont très faibles du point de vue chimique, l'humidité migrant aisément aux interfaces et ceci d'autant plus que les surfaces nettoyées chimiquement ou mécaniquement deviennent hydrophiles après traitement alors qu'elles étaient naturellement hydrophobes avant traitement. Il en résulte que les collages obtenus ne sont pas fiables dans un environnement chaud et humide tel que rencontré pour les onduleurs du domaine ferroviaire.

Le procédé décrit dans le document DE 19 801 135 comprend une étape d'ablation de la surface de carbure de Tungstene par un laser 4AG. Une couche d'agent de couplage est ensuite appliquée sur la surface irradiée, l'agent de couplage étant de préférence un métal noble.

Aussi, un but de la présente invention est de proposer un procédé pour améliorer les propriétés d'adhésion d'un substrat céramique de la famille des non-oxydes en vue de son collage afin d'assurer une grande tenue au collage ainsi qu'une grande fiabilité dans le temps, sans polluer les composants de puissance éventuellement présents sur le substrat, et qui soit simple et économique à réaliser.

A cet effet, l'invention a pour objet un procédé pour améliorer les propriétés d'adhésion d'un substrat céramique de la famille des non-oxydes en vue de son collage, selon la revendication 1.

Selon des modes particuliers de réalisation, le procédé pour améliorer les propriétés d'adhésion d'un substrat céramique de la famille des non-oxydes selon l'invention peut comprendre l'une ou plusieurs des caractéristiques suivantes prises isolément ou selon toutes les combinaisons techniquement possibles :
- la densité d'énergie fournie par le laser excimère est comprise entre 0,5 et 2 J/cm² avec une fréquence de 1 à 100 Hz;
- le laser est un laser excimère du type KrF émettant un rayonnement ultraviolet à 248 nm ;
- le laser est un laser excimère du type ArF émettant un rayonnement ultraviolet à 193 nm;
- le substrat est en AlN, en SiC ou bien en Si₃N₄;
- l'agent de couplage est une solution aqueuse de silane.

L'invention concerne également un procédé d'assemblage par collage d'un substrat céramique de la famille des non-oxydes sur un collecteur de liquide de refroidissement au moyen d'une résine époxy modifiée, caractérisé en ce qu'il comprend une étape de traitement de la surface du substrat à encoller conforme au procédé précédemment décrit et effectuée préalablement au collage du substrat sur le collecteur.

Selon une autre caractéristique du procédé d'assemblage par collage selon l'invention, l'élément plastique est un collecteur de liquide de refroidissement en polyetherimide.

L'invention concerne aussi un module de puissance comportant au moins un composant semi-conducteur de puissance disposé sur une face d'un substrat en céramique de la famille des non-oxydes, le substrat reposant par sa face opposée sur un collecteur canalisant un liquide de refroidissement sur le substrat, caractérisé en que le collecteur est collé au substrat au moyen du procédé d'assemblage par collage précédemment décrit.

On comprendra mieux les buts, aspects et avantages de la présente invention, d'après la description donnée ci-après d'un mode particulier de réalisation de l'invention, présenté à titre d'exemple non limitatif, en se référant aux dessins annexés, dans lesquels :
- la figure 1 est une vue de dessous, d'un substrat destiné à être assemblé par collage sur un collecteur d'eau au moyen du procédé selon l'invention ;
- la figure 2 est une section selon la ligne II-II du collecteur de la figure 1 ;
- la figure 3 est une vue de dessus du collecteur d'eau destiné à être assemblé par collage au substrat de la figure 1 ;
- la figure 4 est une vue en coupe selon la ligne IV-IV du collecteur de la figure 3 ;
- la figure 5 est une vue en coupe illustrant le substrat de la figure 1 assemblé sur le collecteur de la figure 3.

Pour faciliter la lecture du dessin, seuls les éléments nécessaires à la compréhension de l'invention ont été représentés. Les mêmes éléments portent les mêmes références d'une figure à l'autre.

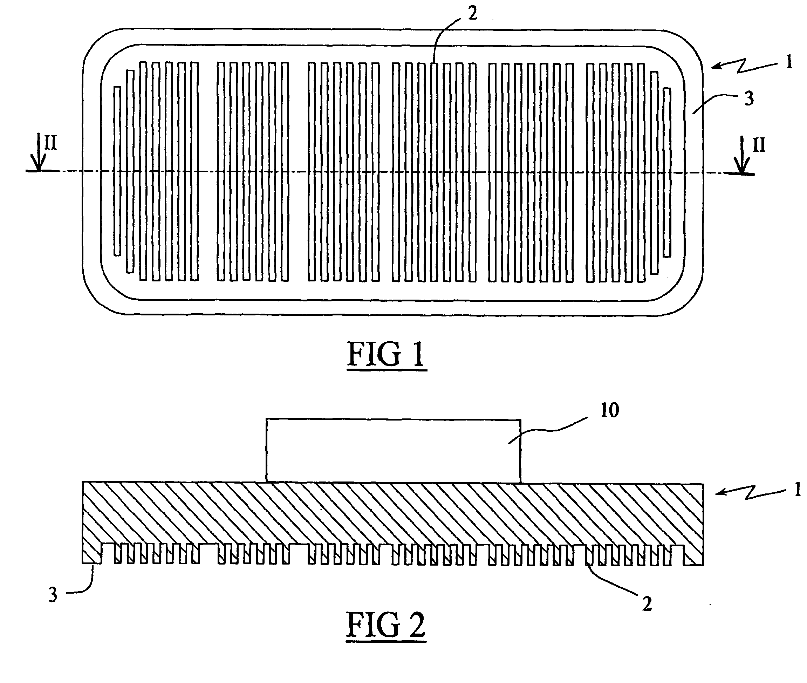

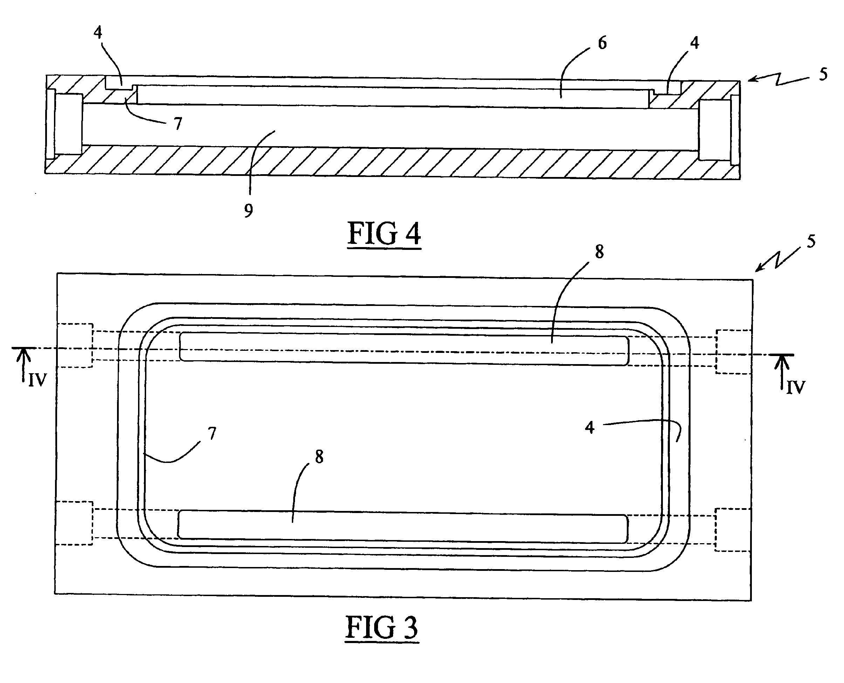

Les figures 1 et 2 représentent un substrat 1 en nitrure d'aluminium AlN comportant une face inférieure munie d'ailettes de refroidissement 2 et une face supérieure plane recevant un composant semi-conducteur de puissance 10. Conformément à ces figures, la périphérie de la face inférieure du substrat comporte une bordure 3 faisant saillie vers le bas, cette bordure 3 étant destinée à être collée sur un collecteur d'eau 5 en polyetherimide représenté sur les figures 3 et 4.

Conformément aux figures 3 et 4, le collecteur d'eau 5 comporte, dans sa partie supérieure, une ouverture 6 bordée d'un rebord 7 munie d'une gorge 4 possédant une forme complémentaire de celle de la bordure 3 du substrat 1. Cette ouverture 6 est fermée dans sa partie inférieure par une paroi présentant localement des fentes 8 débouchant sur des canalisations 9 s'étendant longitudinalement dans le corps du collecteur 5, ces canalisations étant alimentées en eau de refroidissement par leurs extrémités.

Le procédé pour améliorer les propriétés d'adhésion du substrat 1 en vue de son collage sur le collecteur d'eau 5 va maintenant être expliqué.

Un traitement local de la surface de la bordure 3 du substrat 1 en AlN est réalisé au moyen d'un laser excimère. Ce traitement local de la bordure 3 est réalisé avec un laser excimère du type KrF émettant un rayonnement ultraviolet à 248 nm. Dans une variante de réalisation, le traitement local peut aussi être réalisé avec un laser excimère à ArF émettant à 193 nm.

Les conditions pour ce traitement de surface sont une puissance comprise entre 0,5 et 2 J/cm² et de préférence 0.6 à 1 J/cm² avec une fréquence de tirs de 1 à 100 Hz et de préférence de 5 à 20 Hz, pour un nombre de tirs de 1 à 100.

Un tel traitement de surface permet de rompre les liaisons chimiques Al-N et d'obtenir localement un nitrure d'aluminium décomposé. L'aluminium plus ou moins oxydé qui en résulte forme alors aisément une liaison chimique avec un agent de couplage tel qu'une solution aqueuse de silane. Cette application de l'agent de couplage sur la bordure 3 est par exemple réalisée simplement en trempant la bordure 3 du substrat 1 dans un bain de silane.

De manière préférentielle, les silanes utilisés afin d'améliorer la tenue au vieillissement en milieu humide (eau glycolée, eau) de la liaison céramique/polymère sont le γ-glycidoxypropyltriméthoxysilane (γ-GPS) de formule chimique CH₂-O-(CH₂)₃Si(OCH₃)₃ et le γ-aminopropyltriethoxysilane (γ-APS) de formule chimique NH₂-(CH₂)₃Si(OC₂H₅)₃.

Le silane disposé sur la bordure 3 du substrat 1 en AlN est ensuite polymérisé.

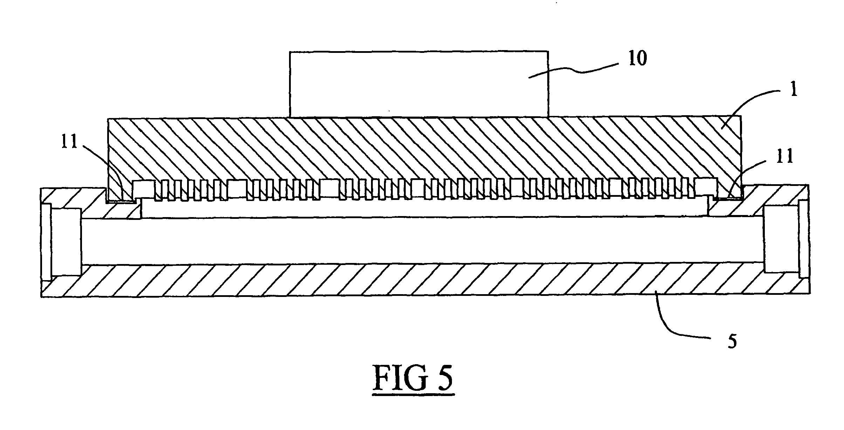

Le collage du substrat 1 sur le collecteur 5 peut ensuite être effectué de manière classique au moyen d'une résine époxy modifiée 11 disposée à l'interface entre la bordure 3 et la gorge 4 ainsi que cela est représenté sur la figure 5.

L'application du silane sur la bordure sera préférentiellement réalisée le plus rapidement possible après l'irradiation de la surface et le collage au moyen de la résine époxy modifiée sera effectué préférentiellement dans les deux jours après la polymérisation du silane. Par ailleurs, les pièces traités suivant le procédé pour améliorer les propriétés d'adhésion selon l'invention seront préférentiellement stockées sous atmosphère contrôlée.

A titre d'exemple, le procédé pour améliorer les propriétés d'adhésion de la bordure 3 du substrat 1 en AlN pourra être constitué des étapes suivantes
- traitement de surface par irradiation par laser KrF à 1 J/cm², 10 Hz et 50 tirs,
- application sur la bordure 3 irradiée d'une solution de γ-GPS à 0,5 % en concentration,
- polymérisation de la solution de γ-GPS déposée sur la bordure 3 à 110°C pendant 15 minutes.

Des essais avec un tel traitement du substrat en ALN ont montré que la durabilité de la liaison par collage du substrat 1 sur le collecteur 5 est augmentée d'un facteur 4 à 16 suivant la nature de la résine époxy utilisée.

Un tel procédé pour améliorer les propriétés d'adhésion selon l'invention présente l'avantage de permettre l'obtention d'un collage durable et fiable présentant des liaisons chimiques fortes. En effet, le silane forme avec le substrat minéral, oxydé par laser excimère, des liaisons covalentes de type siloxane beaucoup moins sensibles à l'eau que les liaisons qui peuvent apparaître lors de la mise en contact d'un polymère avec les mêmes substrats. Il est possible ainsi de freiner la pénétration de l'humidité aux interfaces et donc d'augmenter la durée de vie de l'assemblage notamment dans un environnement chaud et humide.

Le procédé pour améliorer les propriétés d'adhésion selon l'invention présente également l'avantage d'être peu onéreux à mettre en oeuvre, le traitement laser excimère, non polluant, pouvant être utilisé en salle blanche sans enceinte particulière.

Bien entendu, l'invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention. Ainsi, dans des variantes de réalisation de l'invention le substrat pourra être en carbure de silicium SiC ou encore en nitrure de silicium Si₃N₄.

## Revendications

1. Procédé pour améliorer les propriétés d'adhésion d'un substrat céramique (1) de la famille des non-oxydes en vue de son collage comprenant les étapes suivantes :
- irradiation par laser de la surface du substrat (1) céramique à encoller,
- application d'un agent de couplage sur la surface irradié
**caractérisé en ce que** :
- le laser est un laser excimère de manière à ce que l'irradiation de ladite surface par ledit laser conduise à la rupture des liaisons chimiques du substrat céramique et à l'oxydation de la dite surface du substrat céramique,
- l'application d'un agent de couplage sur la surface irradié conduit à l'établissement d'une liaison chimique entre l'agent de couplage et la surface oxydée résultant de l'irradiation du substrat céramique

2. Procédé selon la revendication 1, **caractérisé en ce que** la densité d'énergie fournie par le laser excimère est comprise entre 0,5 et 2 J/cm² avec une fréquence de 1 à 100 Hz.

3. Procédé selon l'une quelconque des revendications 1 à 2, **caractérisé en ce que** ledit laser est un laser excimère du type KrF émettant à 248 nm.

4. Procédé selon l'une quelconque des revendications 1 à 2, **caractérisé en ce que** ledit laser est un laser excimère du type ArF émettant à 193 nm.

5. Procédé selon l'une quelconque des revendications 1 à 4, **caractérisé en ce que** ledit substrat (1) est en AIN, en SiC ou en Si₃N₄.

6. Procédé selon l'une quelconque des revendications 1 à 5, **caractérisé en ce que** l'agent de couplage est une solution aqueuse de silane.

7. Procédé d'assemblage par collage d'un substrat céramique (1) de la famille des non-oxydes sur un collecteur de liquide de refroidissement (5) au moyen d'une résine époxy modifiée (11), **caractérisé en ce qu'**il comprend une étape de traitement de la surface du substrat à encoller conforme au procédé selon l'une quelconque des revendications 1 à 6, effectuée préalablement au collage du substrat (1) sur le collecteur (5).

8. Procédé selon la revendication 7, **caractérisé en ce que** ledit collecteur de liquide de refroidissement (5) est en polyetherimide.

9. Module de puissance comportant au moins un composant semi-conducteur de puissance (10) disposé sur une face d'un substrat (1) de la famille des non-oxydes, ledit substrat (1) reposant par sa face opposée sur un collecteur (5) en plastique canalisant un liquide de refroidissement sur ledit substrat (1), **caractérisé en que** ledit collecteur (5) est collé audit substrat (1) au moyen du procédé selon l'une quelconque des revendications 7 à 8.

## Claims

1. A method for improving the adhesive properties of a ceramic substrate (1) of the family of non-oxides with a view to its gluing, comprising the following stages:
- laser irradiation of the surface of the ceramic substrate (1) to be glued,
- application of a coupling agent to the irradiated surface
**characterised in that**:
- the laser is an excimer laser so that irradiation of the said surface with the said laser results in rupture of the chemical bonds of the ceramic substrate and oxidation of the said surface of the ceramic substrate,
- application of a coupling agent to the irradiated surface results in establishment of a chemical bond between the coupling agent and the oxidised surface resulting from irradiation of the ceramic substrate.

2. A method according to claim 1, **characterised in that** the energy density provided by the excimer laser is between 0.5 and 2 J/cm2 with a frequency of 1 to 100 Hz.

3. A method according to any of claims 1 to 2, **characterised in that** the said laser is an excimer laser of the KrF type emitting at 248 nm.

4. A method according to any of claims 1 to 2, **characterised in that** the said laser is an excimer laser of the ArF type emitting at 193 nm.

5. A method according to any of claims 1 to 4, **characterised in that** the said substrate (1) is in AIN, SiC or Si3N4.

6. A method according to any of claims 1 to 5, **characterised in that** the coupling agent is an aqueous solution of silane.

7. A method of assembly by gluing of a ceramic substrate (1) of the non-oxide class on a cooling liquid manifold (5) by means of modified epoxy resin (11), **characterised in that** it comprises a stage of treatment of the surface of the substrate to be glued in accordance with the method according to any of claims 1 to 6, performed prior to gluing of the substrate (1) to the manifold (5) .

8. A method according to claim 7, **characterised in that** the said cooling liquid manifold (5) is made of polyetherimide.

9. A power module comprising at least one power semiconductor arranged on a face of a substrate (1) of the non-oxide class, with the said substrate (1) resting by its opposite face on a manifold (5) made of plastic channelling a cooling liquid to the said substrate (1), **characterised in that** the said manifold (5) is glued to the said substrate (1) by means of the process according to any of claims 7 to 8.

## Patentansprüche

1. Verfahren zur Verbesserung der Hafteigenschaften eines auf einem Nichtoxid basierenden Keramiksubstrats (1) im Hinblick auf seine Verklebung, die folgenden Schritte umfassend:
- Laserbestrahlung der Oberfläche des zu verklebenden Keramiksubstrats (1),
Auftragen eines Haftvermittlers auf die bestrahlte Oberfläche, **dadurch gekennzeichnet, dass**:
der Laser ein Excimer-Laser ist, so dass die Bestrahlung der Oberfläche durch den Laser zum Brechen der chemischen Bindungen des Keramiksubstrats und der Oxidation der Oberfläche des Keramiksubstrats führt,
das Auftragen eines Haftvermittlers auf die bestrahlte Oberfläche zur Herstellung einer chemischen Bindung zwischen dem Haftvermittler und der aus der Bestrahlung resultierenden oxidierten Oberfläche des Keramiksubstrats führt.

2. Verfahren nach Anspruch 1, **dadurch gekennzeichnet, dass** die von dem Excimer-Laser gelieferte Energiedichte zwischen 0,5 und 2 J/cm2 liegt bei einer Frequenz von 1 bis 100 Hz.

3. Verfahren nach einem der Ansprüche 1 bis 2, **dadurch gekennzeichnet, dass** der Laser ein KrF-Excimer-Laser ist, der bei 248 nm emittiert.

4. Verfahren nach einem der Ansprüche 1 bis 2, **dadurch gekennzeichnet, dass** der Laser ein ArF-Excimer-Laser ist, der bei 193 nm emittiert.

5. Verfahren nach einem der Ansprüche 1 bis 4, **dadurch gekennzeichnet, dass** das Substrat (1) aus AIN, aus SiC oder aus Si3N4 besteht.

6. Verfahren nach einem der Ansprüche 1 bis 5, **dadurch gekennzeichnet, dass** der Haftvermittler eine wässrige Silanlösung ist.

7. Verfahren zur Verklebung eines auf einem Nichtoxid basierenden Keramiksubstrats (1) auf einen Kühlflüssigkeitssammler (5) mittels eines modifizierten Epoxidharzes (11), **dadurch gekennzeichnet, dass** es einen Behandlungsschritt der Oberfläche des zu verklebenden Substrats entsprechend dem Verfahren nach einem der Ansprüche 1 bis 6 umfasst, der vor der Verklebung des Substrats (1) auf den Sammler (5) durchgeführt wird.

8. Verfahren gemäß Anspruch 7, **dadurch gekennzeichnet, dass** der Kühlflüssigkeitssammler (5) aus Polyetherimid besteht.

9. Leistungsmodul mit mindestens einem Leistungshalbleiterbauteil (10), das auf einer Seite eines auf einem Nichtoxid basierenden Substrats (1) angeordnet ist, wobei das Substrat (1) mit seiner abgewandten Seite auf einem Sammler (5) aus Kunststoff aufliegt, der eine Kühlflüssigkeit über das Substrat (1) führt, **dadurch gekennzeichnet, dass** der Sammler (5) mit dem Substrat (1) durch das Verfahren nach einem der Ansprüche 7 bis 8 verklebt ist.
